# EUROPÄISCHE PATENTSCHRIFT

(11) **EP 1 252 656 B1**
(45) Veröffentlichungstag und Bekanntmachung des Hinweises auf die Patenterteilung: **06.05.2009**
(21) Anmeldenummer: 01909642.9
(22) Anmeldetag: 17.01.2001
(51) Int. Cl.: H01L 27/02, H02H 9/04

(54) **SCHUTZANORDNUNG FÜR SCHOTTKY-DIODE**
PROTECTION DEVICE FOR SCHOTTKY DIODES
DISPOSITIF PROTECTEUR POUR DIODE SCHOTTKY

(30) Priorität: 04.02.2000 DE 10004983
(43) Veröffentlichungstag der Anmeldung: 30.10.2002
(73) Patentinhaber: Infineon Technologies AG, 81669 München (DE)
(72) Erfinder: MAUDER, Anton, 83059 Kolbermoor (DE); RUPP, Roland, 91207 Lauf (DE); GRIEBL, Erich, 84405 Dorfen (DE)
(74) Vertreter: Bickel, Michael
(86) Internationale Anmeldenummer: PCT/EP2001/000497
(87) Internationale Veröffentlichungsnummer: WO 2001/057925

(56) Entgegenhaltungen:
- EP-A- 0 646 964
- EP-A- 0 741 412
- EP-A- 0 768 748
- FR-A- 2 689 317
- US-A- 5 789 311

## Beschreibung

Die vorliegende Erfindung betrifft eine Anordnung zum Schutz einer Schottky-Diode vor kurzzeitigen Überstromimpulsen.

Bei zahlreichen Anwendungen von Dioden, in denen diese in rascher Folge abwechselnd in Sperrichtung und in Durchlaßrichtung betrieben werden, wird in den Dioden eine möglichst geringe Speicherladung angestrebt, da durch diese beim Umkommutieren der Dioden Schaltverluste verursacht werden. In dieser Hinsicht sind nun Schottky-Dioden Dioden mit PN-Übergang, also PN-Dioden und PIN-Dioden, deutlich überlegen, da die Schottky-Dioden bekanntlich keine Überschwemmungsladung im Halbleiterkörper besitzen. Aus diesem Grund werden bei Anwendungen, in denen Dioden in schneller Folge abwechselnd in Sperrichtung und in Durchlaßrichtung betrieben sind, an sich bevorzugt Schottky-Dioden eingesetzt.

Nun sind aber wegen der Bandstruktur des üblichen Halbleitermaterials Silizium und der auf dieses aufgebrachten Schottky-Kontakte Schottky-Dioden nur mit einer maximalen Sperrspannung von etwa 200 V bei vertretbaren Sperrströmen zu beaufschlagen. Gegenüber Schottky-Dioden aus Silizium haben Schottky-Dioden aus Halbleitermaterialien mit großem Bandabstand, wie beispielsweise Siliziumcarbid (SiC), den Vorteil einer erheblich höheren Sperrspannung: so kann bei SiC die Sperrspannung Werte über 1700 V erreichen.

Ein Verfahren zur Herstellung einer SiC-Diode ist beispielsweise in der US 5,789,311 beschrieben.

Bei Schottky-Dioden nimmt die Dioden-Durchlaßspannung Vf bei konstantem Strom I mit der Temperatur T der Schottky-Diode zu, wobei beispielsweise bei SiC deren Widerstand R ungefähr proportional zu T^{2,5} ist. Dadurch steigt die Verlustleistung in der Schottky-Diode, was zu einer weiteren Erwärmung führt. Bei Überschreitung eines über eine feste zeit angelegten kritischen Stromes ergibt sich so eine starke nichtlineare Erhöhung der Dioden-Durchlaßspannung Vf.

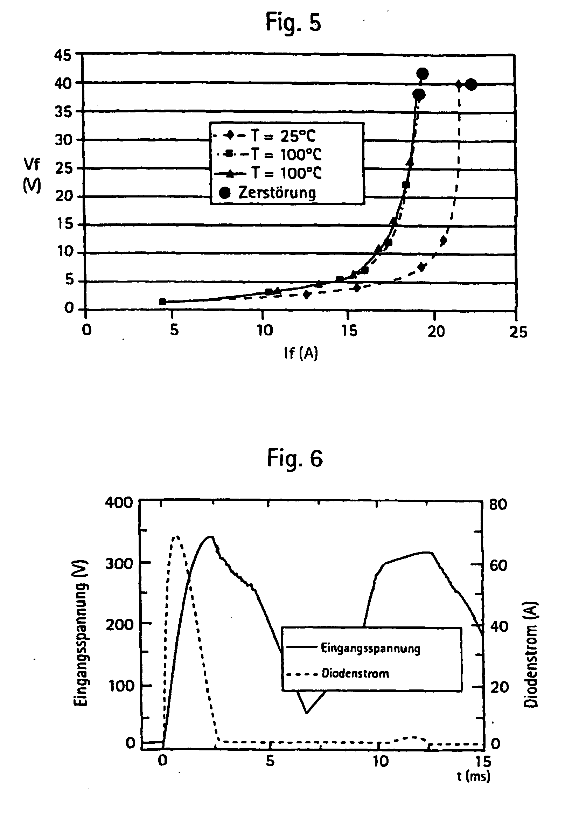

Dieser Zusammenhang ist in der Fig. 5 gezeigt, in welcher die Dioden-Durchlaßspannung Vf in Abhängigkeit von dem Dioden-Durchlaßstrom If für drei verschiedene Dioden bei einer Temperatur von 25°C und zweimal bei einer Temperatur von 100°C aufgetragen ist. Als Dioden wurden dabei auf 4 A (DC bzw. Gleichstrom) ausgelegte SiC-Schottky-Dioden verwendet, an die für eine Zeit von jeweils 10 ms sinusförmige Überstromimpulse angelegt und die Scheitelwerte der Dioden-Durchlaßspannung Vf gemessen wurden. Stromwerte, an denen eine Zerstörung der Diode eingetreten ist, sind durch schwarze Punkte angedeutet.

Bei den verschiedensten elektronischen Schaltungen können bekanntlich kurzzeitige aperiodische Überstromspitzen auftreten. Dies ist beispielsweise der Fall, wenn beim Einschalten einer solchen elektronischen Schaltung Stützkondensatoren aufgeladen werden. Die durch solche Überstromspitzen beanspruchten Bauelemente müssen für diese aperiodischen Belastungen ausgelegt sein. Sie werden daher in der Regel überdimensioniert, was aber die weiteren dynamischen Eigenschaften der Bauelemente verschlechtert und zu höheren Kosten für diese führt.

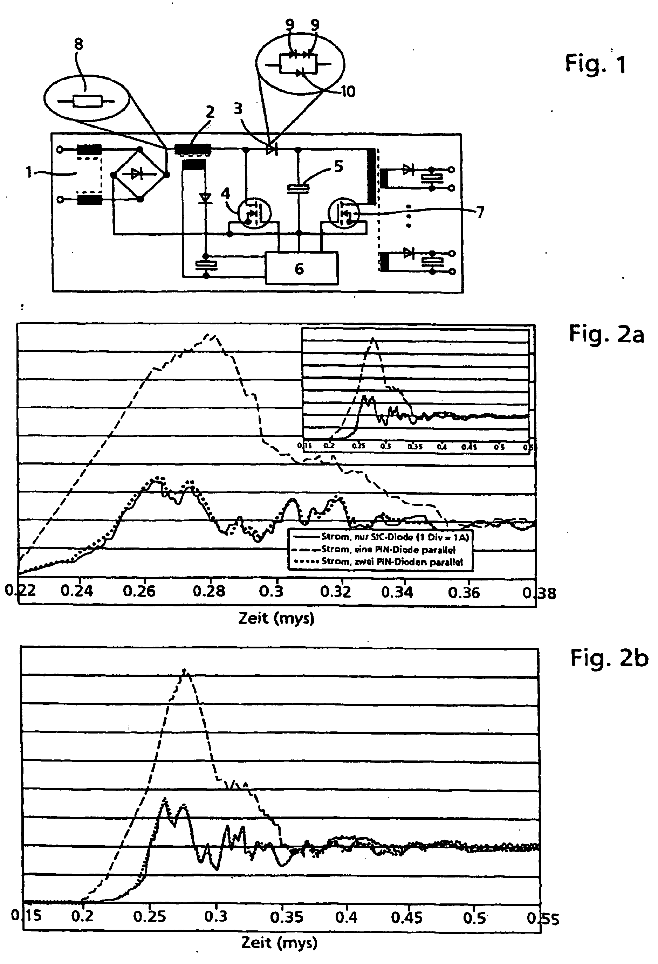

Als Beispiel sei eine weiter unten im Zusammenhang mit Fig. 1 näher erläuterte ungeschützte PFC-Stufe (PFC = power factor correction) eines Schaltnetzteiles genannt. Bei einer solchen PFC-Stufe sind nach dem Einschalten der Netzversorgung die MOSFET-Schalter zunächst gesperrt, wobei in diesem Zustand der Stützkondensator aufgeladen wird. Als Beispiel kann bei einem auf 300 W ausgelegten Schaltnetzteil die Kapazität des Stützkondensators bis zu etwa 220 µF betragen. Der über die Diode dieser PFC-Stufe fließende Strom erreicht dann ein Maximum bis zu 70 A, und die I²t-Helastung kann Werte in der Größenordnung von über 4A²s annehmen, wie dies auch aus der Fig. 6 ersehen werden kann, in welcher die Eingangsspannung eines 300 W-Netzteiles sowie der Diodenstrom der Si-PIN-Diode dieses Netzteiles in Abhängigkeit von der Zeit t nach dem Einschalten aufgetragen sind.

Derzeit werden üblicherweise verschiedene Maßnahmen in Erwägung gezogen, um Si-PIN-Dioden bzw, das Stromversorgungsnetz vor Einschaltstromspitzen zu schützen:
Zunächst kann daran gedacht werden, die Dioden einer Überdimensionierung zu unterziehen, so daß sie zu erwartende Stromspitzen auf jeden Fall aushalten. Durch eine solche Überdimensionierung ergibt sich aber eine Steigerung der Speicherladung, was erhöhte Schaltverluste im Betrieb und höhere Bauteilkosten mit sich bringt.

Weiterhin kann ein Heißleiter-Widerstand (NTC) mit den Dioden in Reihe geschaltet werden. Beispielsweise können Heißleiter-Widerständen mit Kalt-Widerstandswerten von etwa 10 W eingesetzt werden, um bei Netzteilen mit höherer Leistung über 250 W Einschaltstromspitzen zu vermindern, damit Netzstörungen und ein Auslösen von Sicherungsautomaten vermieden wird. Bei Verwendung von solchen Heißleiter-Widerständen ergibt sich aber im Betriebszustand ein Restwiderstand von etwa 0,5 W für ein 300 W-Netzteil, was zu einer zusätzlichen stationären Verlustleistung von ungefähr 1 W am Heißleiter-Widerstand führt.

Bei höherwertigen Netzteilen können auch sogenannte "Boot-Strap"-Widerstände eingesetzt werden, welche ähnlich wie Heißleiter-Widerstände zu den Dioden in Reihe geschaltet sind. Ein parallel zu diesen Boot-Strap-Widerständen liegender Halbleiterschalter, wie insbesondere ein IGBT (Bipolartransistor mit isoliertem Gate) oder ein Thyristor, schließt dann den Boot-Strap-Widerstand nach einem Einschalten kurz. Eine derartige Maßnahme ist relativ aufwendig, wobei aber praktisch keine zusätzliche Verlustleistung im Normalbetrieb auftritt.

Wie bereits eingangs erwähnt wurde, haben Schottky-Dioden den Vorteil einer extrem niedrigen Sperrverzögerungsladung, wobei "Wide-Band-Gap"-Schottky-Dioden (Schottky-Dioden mit breitem Bandabstand), basierend auf Halbleitermaterialien mit großem Bandabstand, zusätzlich hohe Sperrspannungen bei kleinen Leckströmen erreichen. Aus diesem Grund ist der Einsatz von beispielsweise SiC-Schottky-Dioden in PFC-Stufen von Schaltnetzteilen eine schon seit längerer Zeit in Erwägung gezogene Möglichkeit, bei solchen Schaltnetzteilen einen in schneller Folge abwechselnden Betrieb in Sperrichtung und in Durchlaßrichtung zu realisieren. Dies führt im Vergleich zu konventionellen PIN-Dioden zu minimierten dynamischen Verlusten.

Da nun aber derartige Schottky-Dioden äußerst empfindlich auf hohe Einschaltströme reagieren, wie dies bereits eingangs erwähnt wurde, sollten sie in jedem Fall vor solchen Einschaltstromspitzen geschützt werden.

Die oben für PIN-Dioden in Erwägung gezogenen Schutzmaßnahmen werfen aber bei ihrem Einsatz für Schottky-Dioden besondere Probleme auf:
Eine starke Überdimensionierung der Diodenfläche ist weniger wegen der zunehmenden Speicherladung, sondern mehr wegen der Kosten des Grundmaterials für diese Schottky-Dioden kritisch. Insbesondere gilt dies für Verbindungshalbleiter wie beispielsweise SiC.

Bei Einsatz eines Heißleiter-Widerstandes ist beispielsweise zum Schutz einer SiC-Schottky-Diode mit einem Dauerstrom von 4 A für ein 300 W-Netzteil ein Heißleiter-Widerstand mit einem Kalt-Widerstandswert von 20 W erforderlich, damit die SiC-Diode wirksam geschützt werden kann, wie Versuche ergeben haben. Ein solcher Heißleiter-Widerstand erhöht aber die Verlustleistung im Normalbetrieb deutlich. Außerdem müßte auch bei Netzteilen mit kleinerer Leistung immer ein Heißleiter-Widerstand eingebaut werden. Bei Verwendung eines Heißleiter-Widerstandes muß weiterhin eine Verzögerung von ca. 10 s beim Wiedereinschalten eingehalten werden, in welcher der Heißleiter abkühlen kann.

Die Verwendung eines Boot-Strap-Widerstandes ist theoretisch ohne weiteres möglich. Sie scheidet aber in der Praxis bei den meisten Anwendungen aus Kostengründen aus.

Schließlich könnte insbesondere bei Halbleitermaterialien mit großem Bandabstand noch daran gedacht werden, die Schottky-Diode durch beispielsweise einen P⁺-dotierten Schutzring zu umgeben. Diese Maßnahme ist aber mit einer deutlichen Erhöhung des Flächenbedarfes für den Chip der Schottky-Diode um etwa 20 % verbunden. Die hohen Waferkosten für solche Halbleitermaterialien und die Notwendigkeit weiterer Prozeßschritte schränken die Anwendbarkeit dieser Lösung ein.

Es ist daher Aufgabe der vorliegenden Erfindung, eine Anordnung zum Schutz einer Schottky-Diode anzugeben, die diese vor kurzzeitigen Überstromimpulsen zuverlässig und ohne großen Aufwand zu schützen vermag.

Diese Aufgabe wird durch eine Anordnung gemäß der Merkmale des Anspruchs 1 gelöst.

Die Schottky-Diode besteht vorzugsweise aus einem Verbindungshalbleiter und weist einen großen Bandabstand auf. Ein geeignetes Halbleitermaterial ist SiC. Jedoch kann beispielsweise auch GaN verwendet werden.

Bei der erfindungsgemäßen Anordnung wird also ein ausreichender Schutz der Schottky-Diode durch Parallelschalten zweier in Reihe liegender Si-PIN-(oder Si-PN-)Dioden gewährleistet, was insbesondere für einen Betrieb bei einem Einschaltstrom gilt. Es können aber auch mehr als zwei Si-PIN- bzw. Si-PN-Dioden verwendet werden. Spätestens in dem Strombereich, für den die Schottky-Diode einen starken Anstieg der Dioden-Durchlaßspannung Vf zeigt (vg1. Fig. 5), übernehmen die PIN-(oder PN-)Dioden den Hauptanteil des Stromes. Im Normalbetrieb fällt beispielsweise an einer SiC-Schottky-Diode eine Spannung Vf von etwa 1,4 V ab. Die PIN-(oder PN-)Dioden sind dann nicht aktiv (die Schwellenspannung von Si-PN-Dioden beträgt ungefähr 0,73 V, so daß diese Spannung bei zwei Dioden in Reihenschaltung einen Wert von etwa 1,46 V annimmt), und es fällt durch sie nur eine vernachlässigbar kleine zusätzliche Speicherladung an.

Nachfolgend wird die Erfindung anhang der Zeichnungen näher erläutert. Es zeigen:
- Fig. 1: den prinzipiellen Aufbau eines Schaltnetztei- les mit einer PFC-Stufe,
- Fig. 2a und 2b: den Verlauf von Rückstromspitzen bei ver- schiedenen Diodenkonfigurationen im Betrieb einer PFC-Stufe, wobei einer SiC-Diode eine oder zwei Si-PIN-Dioden parallelgeschaltet sein können,
- Fig. 3: den Aufbau einer herkömmlichen Si-PIN-Diode,
- Fig. 4a und 4b: den Aufbau einer Si-Doppeldiode (Fig. 4a) und einer Doppeldiode, bei der ein Dotierungsge- biet durch einen Schottky-Kontakt ersetzt ist (Fig. 4b),
- Fig. 5: den Verlauf der Dioden-Durchlaßspannung Vf in Abhängigkeit von dem Dioden-Durchlaßstrom If und
- Fig. 6: den Strom- bzw. Spannungsverlauf beim Ein- schalten eines 300 W-Netzteiles unter Verwen- dung einer Si-PIN-Diode.

Die Fig. 5 und 6 sind bereits eingangs erläutert worden.

Fig. 1 zeigt den prinzipiellen Aufbau eines Schaltnetzteiles mit einer PFC-Stufe. Einem Eingang 1 sind eine Brückenschaltung, eine Drossel 2 und eine Diodeneinrichtung 3 nachgeschaltet. Die Diodeneinrichtung 3 ist einerseits mit einem Schalttransistor 4 und andererseits mit einem Stützkondensator 5 verbunden. Ein Controller 6 ist mit den Gateelektroden des Schalttransistors 4 und eines weiteren Schalttransistors 7 verbunden. Er steuert und mißt den Ladezustand des Stützkondensators 5 und steuert das Schaltnetzteil.

Außerdem kann der Drossel 2 noch ein Heißleiter-Widerstand 8 vorgeschaltet sein.

Erfindungsgemäß wird für die Diodeneinrichtung 3 die Parallelschaltung einer Reihenschaltung aus zwei 2 Si-PIN- (oder PN-)Dioden 9 mit einer Schottky-Diode 10 verwendet, wobei die Schottky-Diode 10 aus einem Halbleitermaterial mit einem Bandabstand größer als der Bandabstand von silizium hergestellt ist. Für die Schottky-Diode 10 kann beispielsweise eine SiC-Schottky-Diode verwendet werden.

Die prinzipielle Funktionsweise einer PFC-Stufe ist beispielsweise in M. Herfurth: "Power Factor Controller TDA 4862 Applications", Siemens AT2 9402 E, beschrieben.

Wie bereits eingangs erläutert wurde, wird durch Parallelschalten der zwei in Reihe liegenden Si-PIN-Dioden 9 zu der Schottky-Diode 10 die Schottky-Diode 10 vom Einschaltstrom entlastet. Spätestens in dem Strombereich, für den die Schottky-Diode einen starken Anstieg der Durchlaßspannung Vf zeigt, übernehmen die PIN-Dioden 9 den Hauptanteil des Stromes. Im Normalbetrieb fällt beispielsweise an einer SiC-Schottky-Diode eine Spannung Vf von nur etwa 1,4 V ab. Die Si-PIN-Dioden 9 sind dann bei einer Schwellenspannung von 2 x 0,73 V = 1,46 V nicht aktiv, und es fällt durch sie nur eine vernachlässigbar kleine zusätzliche Sperrverzögerungsladung an.

Fig. 2a und 2b zeigen Schaltkurven, die mit dem für 300 W ausgelegten Schaltnetzteil von Fig. 1 erhalten sind, wobei Fig. 2a den zeitlichen Verlauf von 0,22 µs bis 0,38 µs und Fig. 2b den zeitlichen Verlauf von 0,15 µs bis 0,55 µs nach einem Schaltvorgang veranschaulichen und in Fig. 2a rechts oben Fig. 2b für Vergleichszwecke einprojiziert ist.

Ist die Diode 10 eine SiC-Schottky-Diode und wird ihr nur eine Si-PIN-Diode parallelgeschaltet (vgl. den Kurvenverlauf in Strichlinie), so wird diese Diode 9 eingeschaltet und verursacht eine entsprechende Rückstromspitze. Liegen dagegen zu der SiC-Schottky-Diode zwei in Reihe geschaltete Si-PIN-(oder PN-)Dioden parallel-(vgl. den Kurvenverlauf in Punktlinie), so erfolgt kein Einschalten und die Speicherladung ist vergleichbar mit einer solchen ohne weitere Diodenbeschaltung (vgl. den Kurvenverlauf in Volllinie).

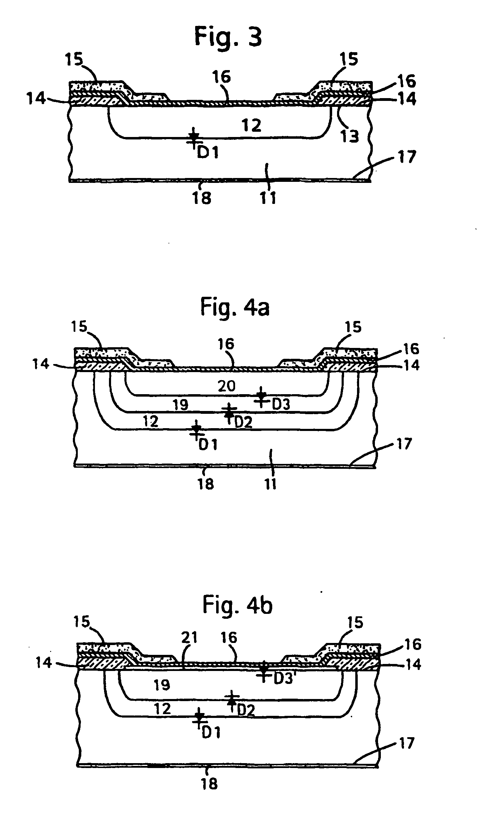

Fig. 3 zeigt eine herkömmliche PN-Hochspannungsdiode für 600 V mit einem n⁻-leitenden Silizium-Halbleiterkörper 11, in den eine p-leitende Zone 12 beispielsweise durch Diffusion eingebracht ist. Auf einer ersten Oberfläche 13 des Halbleiterkörpers 11 bzw. der Zone 12 befinden sich eine Rand-Oxidschicht 14, eine Polyimid-Schicht 15 und eine Metall-Kontaktschicht 16 aus beispielsweise Aluminium, während auf einer zur Oberfläche 13 gegenüberliegenden Oberfläche 17 des Halbleiterkörpers 11 eine weitere Metall-Kontaktschicht 18 vorgesehen ist. Die Diode selbst ist durch ein Symbol D1 am PN-Übergang dargestellt.

Auf diese herkömmliche Hochspannungsdiode, welche im Sperrfall die Spannung aufnimmt, wird, wie in Fig. 4a gezeigt ist, erfindungsgemäß eine weitere N-dotierte Schicht 19 aufgebracht, deren Dotierungsdosis kleiner als die der Flächendurchbruchsladung ist und unterhalb 1,8 x 10¹² cm⁻² liegt.

Eine sich zwischen der Schicht 19 und der Zone 12 bildende Diode D2 ist in Sperrichtung gepolt, wenn die Diode D1 in Durchlaßrichtung liegt. Anschließend wird noch eine p⁺-leitende Schicht 20 in die Schicht 19 eingebracht.

Es sei angemerkt, daß die Schichten 19, 20 und die Zone 12 jeweils durch Diffusion und/oder Ionenimplantation erzeugt werden können.

Mit der Schicht 20 bildet sich zwischen dieser und der Schicht 19 eine Diode D3. Die Diode D3 ist mit der Diode D1 in Flußrichtung gepolt, wenn die Diode D2 in Sperrichtung angeordnet ist.

Anstelle der Schicht 20 kann gegebenenfalls auch ein Schottky-Kontakt 21 aufgebracht werden, welcher die Diode D3 bildet (vgl. Fig. 4b). Die Schicht bzw. der Bereich 20 kann dann entfallen.

Bei der in Fig. 4a gezeigten Anordnung bildet sich eine Raumladungszone in den p- und n-leitenden Schichten 19, 20 und der p-leitenden Zone 12 aus. Ist die n-leitende Schicht 19 an Ladungsträgern ausgeräumt, so stößt die Raumladungszone vom PN-Übergang zwischen der Zone 12 und der Schicht 19 zur Schicht 20 durch. Die Durchgriffspannung in Vorwärtsrichtung kann sogar noch in bestimmten Grenzen durch die Dotierungen und die Breite der N-leitenden Schicht 19 eingestellt werden.

Die Schottky-Diode 10 und die Si-PIN-(bzw. PN-)Dioden 9 können entweder als einzelne Chips oder als Si-Doppeldiode (vg1. Fig. 4a, b) in einem Gehäuse untergebracht werden, was die Montage der Anordnung erheblich erleichtert.

Der Aufwand für die Si-Doppeldiode wird bei Verbindungshalbleitern ohne weiteres durch die Verkleinerung der Fläche kompensiert, die für eine derartige Schottky-Diode durch die völlige Vermeidung eines Überstromes möglich ist.

In dem obigen Ausführungsbeispiel sind die beiden Dioden D1 und D3 in Reihe geschaltet. Gegebenenfalls können noch weitere Dioden hierzu in Reihe vorgesehen werden, so daß parallel zu der Schottky-Diode mehrere Si-PIN- bzw. -PN-Dioden in Reihe liegen. Diese Si-PIN- bzw. -PN-Dioden können, wie in Fig. 4a und 4b gezeigt ist, ohne weiteres in einem Halbleiterkörper integriert sein.

## Patentansprüche

1. Anordnung zum Schutz einer Schottky-Diode vor kurzzeitigen Überstromimpulsen,
**dadurch gekennzeichnet, daß**
parallel zu der Schottky-Diode (10) eine Reihenschaltung aus wenigstens zwei si-PIN- bzw. -PN-Dioden (9) vorgesehen ist, wobei die Schottky-Diode (10) aus einem Halbleitermaterial mit einem Bandabstand größer als der Bandabstand von Silizium hergestellt ist.

2. Anordnung nach Anspruch 1,
**dadurch gekennzeichnet, daß**
die Schottky-Diode (10) aus einem Verbindungshalbleiter hergestellt ist.

3. Anordnung nach Anspruch 1 oder 2,
**dadurch gekennzeichnet, daß**
die Schottky-Diode (10) aus SiC oder GaN hergestellt ist.

4. Anordnung nach einem der Ansprüche 1 bis 3,
**dadurch gekennzeichnet, daß**
die wenigstens zwei'Si-PIN- bzw. -PN-Dioden (9) in einem Siliziumkörper integriert sind.

5. Anordnung nach einem der Ansprüche 1 bis 4,
**dadurch gekennzeichnet, daß**
zu den wenigstens zwei Si-PIN- bzw. -PN-Dioden (9) noch eine Schottky-Diode (D3') in Serie zu den PIN- bzw. PN-Dioden (9) in einem Siliziumkörper integriert sind.

6. Anordnung nach einem der Ansprüche 1 bis 5,
**dadurch gekennzeichnet, daß**
die Schottky-Diode (10) und die wenigstens zwei Si-PIN- bzw. -PN-Dioden (9) gemeinsam in einem Gehäuse vorgesehen sind.

7. Anordnung nach einem der Ansprüche 1 bis 6,
**dadurch gekennzeichnet, daß**
die Schottky-Diode (10) und die wenigstens zwei Si-PIN- bzw. -PN-Dioden (9) in einer PFC-Stufe eines Schaltnetzteiles vorgesehen sind.

8. Anordnung nach Anspruch 6 oder 7,
**dadurch gekennzeichnet, daß**
auch die in Serie zu den PIN- bzw. PN-Dioden liegende Schottky-Diode (D3') in dem gemeinsamen Gehäuse bzw. in der PFC-Stufe vorgesehen ist.

9. Anordnung nach einem der Ansprüche 1 bis 8,
**dadurch gekennzeichnet, daß**
eine N-dotierte Schicht der Reihenschaltung aus zwei Si-PIN- bzw. -PN-Dioden eine Flächendurchbruchsladung hat, die kleiner als 1,8 x 10¹² cm⁻² Ladungsträger ist.

## Claims

1. Arrangement for protecting a Schottky diode from transient overcurrent pulses,
**characterized in that**
a series connection of at least two Si-PIN diodes or Si-PN diodes (9) is provided in parallel with the Schottky diode (10), the Schottky diode (10) being made of a semiconductor material having a larger band gap than the band gap of silicon.

2. Arrangement according to Claim 1,
**characterized in that**
the Schottky diode (10) is made of a compound semiconductor.

3. Arrangement according to Claim 1 or 2,
**characterized in that**
the Schottky diode (10) is made of SiC or GaN.

4. Arrangement according to any of Claims 1 to 3,
**characterized in that**
the at least two Si-PIN diodes or Si-PN diodes (9) are integrated in a silicon substrate.

5. Arrangement according to any of Claims 1 to 4,
**characterized in that**
in addition to the at least two Si-PIN diodes or Si-PN diodes (9), a Schottky diode (D3') is integrated in series with the PIN diodes or PN diodes (9) in a silicon substrate.

6. Arrangement according to any of Claims 1 to 5,
**characterized in that**
the Schottky diode (10) and the at least two Si-PIN diodes or Si-PN diodes (9) are provided in a shared package.

7. Arrangement according to any of Claims 1 to 6,
**characterized in that**
the Schottky diode (10) and the at least two Si-PIN diodes or Si-PN diodes (9) are provided in a PFC stage of a switched-mode power supply.

8. Arrangement according to Claim 6 or 7,
**characterized in that**
the Schottky diode (D3') lying in series with the PIN diodes or PN diodes is also provided in the shared package or in the PFC stage.

9. Arrangement according to any of Claims 1 to 8,
**characterized in that**
an N-type layer of the series connection of two Si-PIN diodes or Si-PN diodes has a breakdown surface charge density that is less than 1.8 x 10¹² cm⁻².

## Revendications

1. Dispositif de protection d'une diode Schottky contre les impulsions de surintensité, brèves,
**caractérisé en ce qu'**
un montage en série composé d'au moins deux diodes Si-PIN ou PN (9), est en parallèle à la diode Schottky (10) la diode Schottky (10) étant réalisée en matière semiconductrice avec un intervalle d'énergie entre deux bandes, supérieur à celui du silicium.

2. Dispositif selon la revendication 1,
**caractérisé en ce que**
la diode Schottky (10) est fabriquée en un semi-conducteur composé.

3. Dispositif selon les revendications 1 ou 2,
**caractérisé en ce que**
la diode Schottky (10) est en SiC ou GaN.

4. Dispositif selon l'une des revendications 1 à 3,
**caractérisé en ce qu'**
au moins deux diodes Si-PIN ou PN (9) sont intégrées dans un corps en silicium.

5. Dispositif selon l'une des revendications 1 à 4,
**caractérisé en ce que**
pour au moins deux diodes Si-PIN ou PN (9) on a intégré en série encore une diode Schottky (D3') par rapport aux diodes PIN ou PN (9) dans le corps en silicium.

6. Dispositif selon l'une des revendications 1 à 5,
**caractérisé en ce que**
la diode Schottky (10) et au moins deux diodes Si-PIN et PN (9) sont logées en commun dans un boîtier.

7. Dispositif selon l'une des revendications 1 à 6,
**caractérisé en ce que**
la diode Schottky (10) et au moins deux diodes Si-PIN et PN (9) sont prévues dans un étage PFC d'une partie de réseau de commutation.

8. Dispositif selon l'une des revendications 6 ou 7,
**caractérisé en ce qu'**
également la diode Schottky (D3') en série sur les diodes PIN ou PN est logée dans le boîtier commun ou dans l'étage PFC.

9. Dispositif selon l'une des revendications 1 à 8,
**caractérisé en ce qu'**
une couche à dopage N du montage en série formé des deux diodes Si-PIN ou PN a une charge de claquage de surface, inférieure à 1,8 x 10¹² cm⁻² de porteurs de charge.
